(19) Europäisches Patentamt
European Patent Office
Office européen des brevets

(11) EP 4 760 325 A1

(12) **EUROPÄISCHE PATENTANMELDUNG**

(43) Veröffentlichungstag:
17.06.2026 Patentblatt 2026/25

(21) Anmeldenummer: 24219415.7

(22) Anmeldetag: 12.12.2024

(51) Internationale Patentklassifikation (IPC):
*G01R 33/36* *(2006.01)*

(52) Gemeinsame Patentklassifikation (CPC):
G01R 33/3621; G01R 33/3692

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
GE KH MA MD TN

(71) Anmelder: Siemens Healthineers AG
91301 Forchheim (DE)

(72) Erfinder: BOLLENBECK, Jan
91330 Eggolsheim (DE)

(74) Vertreter: Siemens Healthineers
Patent Attorneys
Postfach 22 16 34
80506 München (DE)

(54) **LOKALSPULE MIT ANALOG-DIGITAL-WANDLER, MISCHER, OSZILLATOR UND DEZIMATOR**

(57) Die Erfindung betrifft eine Lokalspule für einen Magnetresonanztomographen mit einem Analog-Digitalwandler und einem digitalen Mischer, einem Oszillator und einem Datenraten-Dezimator. Der Mischer und der Oszillator sind ausgebildet, ein digitales Magnetresonanzsignal derart mit einem IQ-Oszillatorsignal herunterzumischen, dass das Magnetresonanzsignal am Ausgang des folgenden Datenraten-Dezimators als reellwertiges Niedrig-Zwischenfrequenzsignal ("Low-IF-Signal") mittig in einen Frequenzbereich, der wahlweise dem positiven Frequenzteilbereich oder dem negativen Frequenzteilbereich des Basis-Bandes entspricht, umgesetzt wird.

FIG 2

EP 4 760 325 A1

**Beschreibung**

*Unabhängig vom grammatikalischen Geschlecht eines bestimmten Begriffes sind Personen mit männlicher, weiblicher oder anderer Geschlechteridentität mit umfasst.*

Die Erfindung betrifft eine Lokalspule für einen Magnetresonanztomographen und einen Magnetresonanztomographen mit einer Lokalspule. Die Lokalspule weist einen Analog-Digital-Wandler auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Zunehmend wird eine Digitalisierung der empfangenen Magnetresonanzsignale bereits in der Lokalspule angestrebt, insbesondere in Verbindung mit drahtlosen Lokalspulen, um die zu übertragenden Datenraten bereits in der Lokalspule zu reduzieren. Die digitale Signalverarbeitung mit unterschiedlichen Schaltzeiten und mit den digitalen Signalfomrn verbundenen Oberwellen kann aber zusätzliche Störsignale in dem Patiententunnel verursachen.

Es ist daher eine Aufgabe der Erfindung, eine digitale Lokalspule zu verbessern.

Die Aufgabe wird durch eine erfindungsgemäße Lokalspule nach Anspruch 1 gelöst.

Die erfindungsgemäße Lokalspule ist zur Anwendung mit einem Magnetresonanztomographen ausgebildet, um Magnetresonanzsignale mit möglichst hohem Signal-zu-Rausch-Verhältnis zu erfassen und in digitaler Form dem Magnetresonanztomographen zur Auswertung und Bilderzeugung zu übermitteln.

Die erfindungsgemäße Lokalspule weist einen Analog-Digital-Wandler auf, mit dem das erfasste Magnetresonanzsignal digitalisiert wird. Das Magnetresonanzsignal wird üblicherweise mit einer oder mehreren Induktions- bzw. Antennenspulen aufgenommen. Üblicherweise weisen die Lokalspulen im analogen Signalpfad bis zu dem Analog-Digital-Wandler weiterhin Elemente zur Anpassung der Impedanz und einen Vorverstärker auf. Auch ist es denkbar, dass zunächst eine Umsetzung durch Analoge Mischer und/oder eine Filterung z.B. durch Bandpässe erfolgt.

Die erfindungsgemäße Lokalspule weist weiterhin einen digitalen Mischer, einen Oszillator und eine Datenraten-Dezimationsstufe auf (DDC, Digital Down Converter). Unter digitaler Mischer bzw. Oszillator werden dabei eine digitale Signalverarbeitungsschaltung oder Programm zur Ausführung auf einem digitalen Prozessor verstanden, die im Gegensatz zu einem analogen Mischer bzw. Oszillator Operationen an den Signalen wie z.B. Multiplikation oder Addition durch arithmetische Operationen auf digitalen Daten bzw. Datenströmen ausführen. Der digitale Mischer ist vorzugsweise ein halb-komplexer Mischer und der der Oszillator ein IQ-Oszillator.

Der digitale Mischer und der digitale Oszillator sind ausgebildet, ein digitales Magnetresonanzsignal derart mit einem IQ-Oszillatorsignal herunterzumischen, dass das Magnetresonanzsignal mit beiden Seitenbändern mittig in einen Frequenzbereich, der einem der beiden ersten Nyquist-Bänder (positive oder negative Frequenz) am Ausgang des folgenden DDCs entspricht, umgesetzt wird. Mit anderen Worten, das Magnetresonanzsignal mit beiden Seiten befindet sich nach der Umsetzung entweder oberhalb der unterhalb der 0-Hz-Linie im Spektrum.

Das Heruntermischen kann beispielsweise durch eine Multiplikation des digitalisierten Magnetresonanzsignals mit dem digitalen IQ-Oszillatorsignal erfolgen.

Der Oszillator kann dabei auch ausgebildet sein, das Oszillatorsignal in Abhängigkeit von einem von außen der Lokalspule zugeführten Referenzsignal mit einer vorbestimmten Frequenz zu erzeugen, beispielsweise von einem von dem Magnetresonanztomographen zugeführten Referenzsignal. Denkbar ist auch, dass der Oszillator das Mischsignal von dem von außen zugeführten Referenzsignal ableitet, beispielsweise durch Frequenzteilung, Frequenzvervielfachung oder durch einen Phase-Lock-Loop-Kreis. Grundsätzlich denkbar ist eine autonome Erzeugung durch den Oszillator, wenn eine genügend Stabile Referenzfrequenz bereitsteht.

Der Oszillator ist ausgebildet, das Oszillatorsignal zum Mischen derart zu erzeugen, dass die Mittenfrequenz des heruntergemischten Magnetresonanzsignals im Wesentlich mittig in einen Frequenzbereich umgesetzt wird, der wahlweise dem positiven Frequenzteilbereich oder dem negativen Frequenzteilbereich des Basis-Bandes am Ausgang des folgenden Datenraten-Dezimators entspricht. Das Basis-Band erstreckt sich symmetrisch zu dem Frequenznullpunkt, wobei das heruntergemischten Magnetresonanzsignals und dessen Mittenfrequenz entweder oberhalb des Nullpunktes in dem positiven Frequenzbereich des Basisbandes oder unterhalb des Nullpunktes im negativen Frequenzbereich des Basisbandes zu liegen kommt.. Mit anderen Worten, nach dem Heruntermischen durch den Mischer liegt ein Signal, dass der Mittenfrequenz des Magnetresonanzsignals entspricht, auf einer Frequenz, die von $F_{BW}$ der halben Nyquist-Frequenz des DDC-Ausgangssignals um weniger als 10%, 5% oder 1% abweicht. Die Mittenfrequenz entspricht dabei der Larmorfrequenz der Spins in dem zu erfassenden Untersuchungsbereich und kann auch als Trägerfrequenz der durch die Sequenz modulierten Kernspinsignale betrachtet werden.

Auf vorteilhafte Weise sorgt die mittige Frequenzlage in einem der beiden ersten Nyquist-Bändern der DDC-Ausgangstaktung für einen gleichen bzw. symmetrischen Abstand zur oberen und unteren Grenze des Frequenzbereichs, was eine Dimensionierung der Filter für die nachfolgende Signalverarbeitung vereinfacht.

Weitere vorteilhafte Ausführungsformen sind zu den Unteransprüchen angegeben.

In einer denkbaren Ausführungsform der erfindungsgemäßen Lokalspule ist der Oszillator ausgebildet, das Oszillatorsignal so zu erzeugen, dass es außerhalb des Frequenzbereichs des abgetasteten MR-Signals liegt. Darunter ist auch zu verstehen, dass auch durch das Heruntermischen das Oszillatorsignal selbst oder Verarbeitung in der Lokalspule abgeleitete Signale wie Harmonische bzw. Frequenzvielfache des Oszillatorsignals auf Frequenzen außerhalb des Frequenzbereichs abgetasteten MR-Signals abgebildet werden. Die Frequenz des Oszillatorsignals ist entsprechend eingestellt, dass in Verbindung mit den Misch- und-Signalverarbeitungsschritten in der Lokalspule ein Frequenzschema angewendet wird, bei dem das von dem Mischer heruntergemischte Magnetresonanzsignal im Frequenzraum zwischen von dem Oszillatorsignal abgeleiteten Signalen bzw. Frequenzen liegt, die beispielsweise durch Mischen, dezimieren oder andere nichtlineare Verarbeitungsschritte aus dem Oszillatorsignal entstehen. Es ist dabei zu berücksichtigen, dass Signale auch durch Über- oder Unterabtastung in den Frequenzbereich des Magnetresonanzsignals umgesetzt werden können.

Auf vorteilhafte Weise sorgt dieses Frequenzschema, das von dem üblichen in IQ-Mischern angewendeten Verfahren abweicht, bei dem das Heruntermischen in das Basisband mit der Mittenfrequenz bei 0 Hz erfolgt, dafür, dass Einkopplungen des Oszillatorsignals in den Analog-Digital-Wandler nicht zu Bildartefakten führen.

In einer möglichen Ausführungsform der erfindungsgemäßen Lokalspule sind der Analog-Digital-Wandler und der DDC monolithisch ausgeführt. Dabei ist unter monolithisch zu verstehen, dass beide Funktionen in einem Baustein, z.B. einem Silizium-Die oder einem Modul der erfindungsgemäßen Lokalspule integriert sind. Insbesondere sind beide Funktionen bzw. die Funktion ausführenden Module nicht galvanisch voneinander getrennt.

Auf vorteilhafte Weise erlaubt die integrierte Bauweise eine kostengünstige und energiesparende Bauweise, wobei das Frequenzschema dazu führt, dass das Oszillatorsignal nicht durch kaum vermeidbare Einkopplung innerhalb des Bausteins zu Störungen in der rekonstruierten Abbildung führt.

In einer denkbaren Ausführungsform der erfindungsgemäßen Lokalspule weist die Lokalspule eine drahtlose Übertragungsvorrichtung auf. Dabei ist die Lokalspule ausgebildet, das heruntergemischte digitale Magnetresonanzsignal drahtlos zu einem Magnetresonanztomographen zu übertragen.

Das heruntergemischte Signal erlaubt eine Bandbreiten-effiziente Übertragung des digitalisierten Magnetresonanzsignals, wobei die energiesparende integrierte Bauform zusätzlich eine längere Betriebsdauer ohne Aufladen einer Batterie erlaubt.

In dem erfindungsgemäßen System aus einem Magnetresonanzsystem und einer erfindungsgemäßen Lokalspule ist die Lokalspule ausgebildet, ein Referenzsignal von dem Magnetresonanztomographen über eine Signalverbindung zu erhalten. Beispielsweise kann die Lokalspule einen Signaleingang für eine optische oder elektrische kabelgebundene oder auch drahtlose Übertragung aufweisen. Der Oszillator ist dabei ausgebildet, eine Mischfrequenz für den Mischer in Abhängigkeit von einem Referenzsignal zu erzeugen, sodass wie bereits ausgeführt das Magnetresonanzsignal mit beiden Seitenbändern im Wesentlich mittig in dem Frequenzbereich des DDC-Ausgangssignals zu liegen kommt. Dazu ist es denkbar, dass der Oszillator das Oszillatorsignal durch Frequenzteilung, Vervielfachung oder mittels PLL umsetzt.

Das erfindungsgemäße System teilt die Vorteile der erfindungsgemäßen Lokalspule.

In einer denkbaren Ausführungsform des erfindungsgemäßen Verfahrens weist das System eine Signalverarbeitungskette für Magnetresonanzsignale auf. Als Signalverarbeitungskette wird eine Abfolge analoger und/oder digitaler Signalverarbeitungsschritte bezeichnet, die zwischen Aufnahme des Magnetresonanzsignals von dem Patienten durch Antennen, beispielsweise Induktionsspulen, erfasst werden, und einer Bildrekonstruktion, beispielsweise mittels FFT oder KI liegen. Die Signalkette betrifft insbesondere Schritte aus einer Gruppe von Verstärken, Filtern, Frequenzumsetzen oder Demodulatoren. Die Signalverarbeitungskette weist mindestens zwei in der Signalverarbeitungskette hintereinander angeordnete Mischer und zwei numerisch gesteuerte Oszillatoren zum Erzeugen von Mischfrequenzen zur Frequenzumsetzung des Magnetresonanzsignals mit den Mischern auf.

In einer möglichen Ausführungsform des erfindungsgemäßen Magnetresonanztomographen ist der Magnetresonanztomograph ausgebildet, ein Frequenz-Abstimm-Wort des ersten und/oder zweiten numerisch gesteuerte Oszillators ohne Rundung als natürliche Zahl zu ermitteln. Mit anderen Worten, die Frequenzen und Teilerfaktoren sind so gewählt, dass sich bei der Berechnung der Frequenz-Abstimmworte natürliche Zahlen ergeben. Beispiele für geeignete Zahlen-Kombination sind nachfolgend in der Figurenbeschreibung ausgeführt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:

Fig. 1   eine schematische Darstellung eines Magnetresonanztomographen mit einer erfindungsgemäßen Lokalspule;

Fig. 2   eine schematische Darstellung der funktionellen Einheiten einer erfindungsgemäßen Lokalspule;

Fig. 3   eine schematische Darstellung der funktionellen Einheiten einer empfangsseitigen Signalverarbeitung eines erfindungsgemäßen Systems;

Fig. 4   eine schematische Darstellung eines Empfangspfades einer Ausführungsform eines erfindungsgemäßen Systems;

Fig. 5   ein beispielhaftes Signalspektrum nach einer A/D-Wandlung des Magnetresonanzsignals;

Fig. 6   ein beispielhaftes Signalspektrum nach einer erfindungsgemäßen Frequenzumsetzung;

Fig. 7   ein beispielhaftes Signalspektrum nach einer erfindungsgemäßen Frequenzumsetzung im Basisband;

Fig. 8   eine beispielhaftes Spektrum einer spektralen Lage eines abgetasteten MR-Signals am Ausgang eines AD-Wandlers.

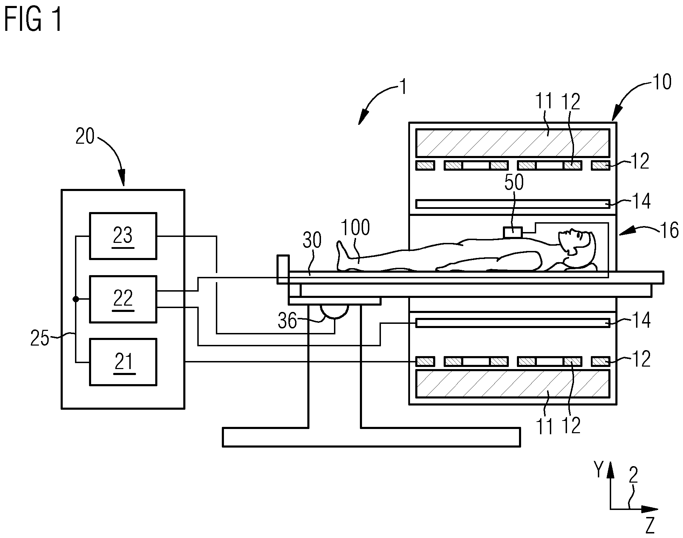

Fig. 1 zeigt eine schematische Darstellung einer beispielhaften Ausführungsform eines Magnetresonanztomographen 1 mit einer erfindungsgemäßen Lokalspule 50.

Der Magnetresonanztomograph 1 weist eine Magneteinheit 10 mit einem Feldmagneten 11 auf, der ein statisches Magnetfeld B0 zur Ausrichtung von Kernspins von Proben bzw. eines Patienten 100 in einem Aufnahmebereich erzeugt. Der Aufnahmebereich ist in einem Patiententunnel 16 angeordnet, der sich in einer Längsrichtung 2 durch die Magneteinheit 10 erstreckt. Ein Patient 100 ist mittels der Patientenliege 30 und der Verfahreinheit 36 der Patientenliege 30 in den Aufnahmebereich verfahrbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Gradienten des statischen Magnetfeldes B0 in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen einzukoppeln und von dem Patient 100 emittierte Resonanzsignale zu empfangen und über eine Signalleitung abzugeben. Bevorzugter Weise wird aber die Körperspule 14 für das Aussenden des Hochfrequenzsignals verwendet und für das Empfangen durch Lokalspulen 50 ersetzt, die in dem Patiententunnel 16 nahe am Patient 100 angeordnet sind. Es ist aber auch denkbar, dass die Lokalspule 50 zum Senden und Empfangen ausgelegt ist und deshalb eine Körperspule 14 entfallen kann.

Eine Steuereinheit 20 versorgt die Magneteinheit 10 mit den verschiedenen Signalen für die Gradientenspulen 12 und die Körperspule 14 und wertet die empfangenen Signale aus. Eine Steuerung 23 koordiniert dabei die Untereinheiten.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die einzelnen Einheiten sind über einen Signalbus 25 untereinander verbunden.

Das von Hochfrequenzeinheit 22 erzeugte Hochfrequenzsignal wird über eine Signalverbindung der Körperspule 14 zugeführt und in den Körper des Patienten 100 ausgesendet, um dort die Kernspins anzuregen. Denkbar ist aber auch ein Aussenden des Hochfrequenzsignals über eine oder mehrere Lokalspulen 50.

Die Lokalspule 50 empfängt dann vorzugsweise ein Magnetresonanzsignal aus dem Körper des Patienten 100, denn aufgrund des geringen Abstandes ist das Signal-zu-Rauschverhältnis (SNR) der Lokalspule 50 besser als bei einem Empfang durch die Körperspule 14. Das von der Lokalspule 50 empfangene MR-Signal wird in der Lokalspule 50 aufbereitet und an die Hochfrequenzeinheit 22 des Magnetresonanztomographen 1 zur Auswertung und Bilderfassung weitergeleitet. Dazu kann die Signalverbindunggenutzt werden, es ist aber beispielsweise auch eine drahtlose Übertragung denkbar.

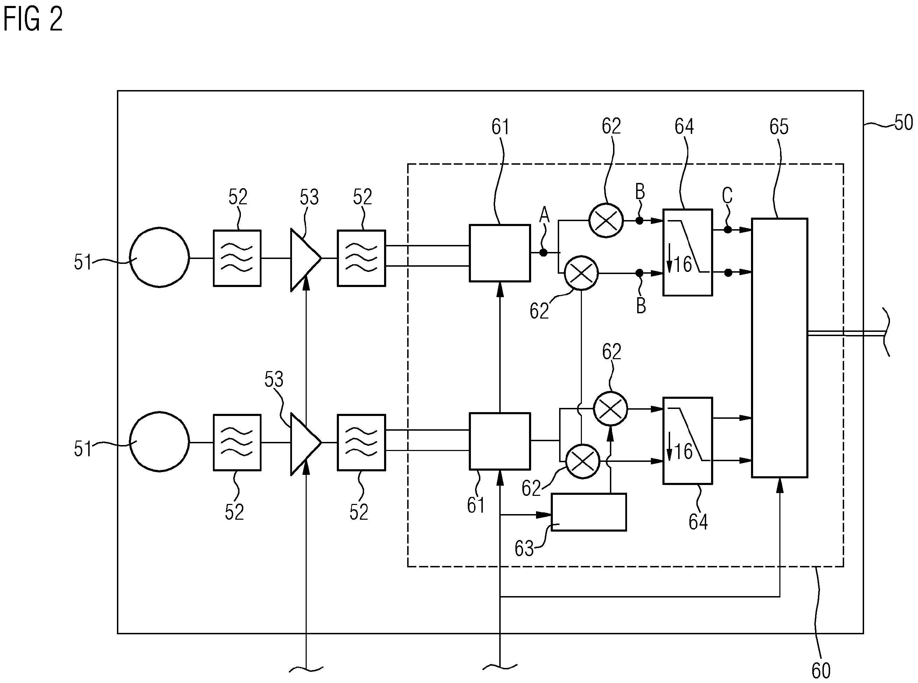

In Fig. 2 werden funktionellen Einheiten einer Ausführungsform einer erfindungsgemäßen Lokalspule in einem schematischen Diagramm dargestellt. Die Darstellung ist nicht vollständig, beispielsweise sind Funktionen wie das Detuning der Übersichtlichkeit halber weggelassen.

Die Magnetresonanzsignale aus dem Körper des Patienten werden von Antennenspulen 51 erfasst und in elektrische Signale gewandelt. Erste Filter 52 begrenzen die weitergereichten Signale auf einen Frequenzbereich der zu erfassenden Magnetresonanzsignale, die durch die Kernspins und das Magnetfeld des Feldmagneten 11 als Larmorfrequenz definiert sind. Das erste Filter 52 sorgt auch dafür, dass starke Signale aus anderen Frequenzbereichen den nachfolgenden Signalpfad nicht übersteuern. Die ersten Filter 52 können auch die Funktion einer Impedanzanpassung der Antennenspule bereitstellen.

Nachfolgend wird das Magnetresonanzsignal durch einen Verstärker 53 in jedem Signalpfad im Pegel angehoben. Der Verstärker 53 ist vorzugsweise ein Verstärker mit einer niedrigen Rauschzahl, der auch als Low-Noise-Amplifier (LNA) bezeichnet wird. In einer bevorzugten Ausführungsform ist der Verstärker 53 in seiner Verstärkung schaltbar, um beispielsweise ein Magnetresonanzsignal am Beginn des exponentiellen Abfalls ohne Übersteuerung zu erfassen und zu einem späteren Zeitpunkt die Auflösung für schwache Signale mit höherer Verstärkung zu verbessern. Das Einstellen der Verstärkung kann durch eine lokale Steuerung der Lokalspule oder durch die Steuerung 23 des Magnetresonanztomographen erfolgen.

Anschließend führt ein zweiter Filter 52 eine Filterung des noch analogen Signals durch, um bei der nachfolgenden Digitalisierung ein Aliasing, also eine Einfaltung aus anderen Frequenzbereichen zu reduzieren.

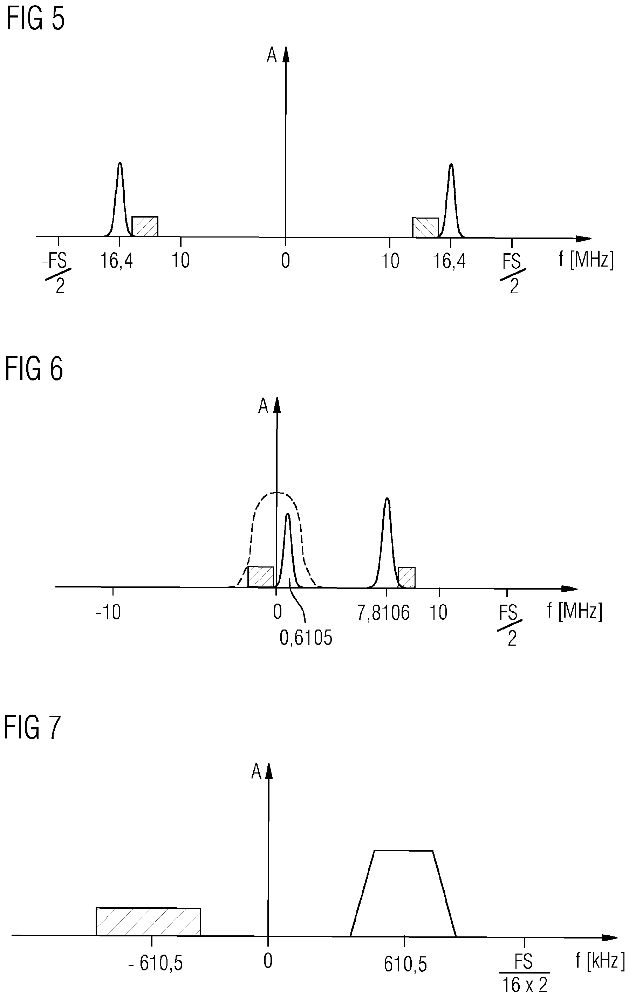

Die weitere, digitale Signalverarbeitung erfolgt vorzugsweise durch ein integriertes AD-Wandlermodul 60, wie der Baustein ADC 3638 von Texas Instruments, der nachfolgend beispielhaft erläutert wird. Durch die Integration der unterschiedlichen Funktionen in einem Modul bzw. integrierten Baustein werden auf vorteilhafte Weise Kosten und Energieverbrauch und damit auch Abwärme der Lokalspule reduziert. Durch die Miniaturisierung reduziert sich die Kopplung, wobei allerdings eine Abschirmung der einzelnen Signalverarbeitungsschritte innerhalb eines integrierten Bausteins nicht mehr vollständig möglich ist. Deshalb ist eine erfindungsgemäße Wahl der Signalfrequenzen erforderlich, um zu verhindern, dass sich eingekoppelte Signale, wie Taktsignale oder NCO-Signale, störend auf die rekonstruierten Bilder auswirken. Dies ist nachfolgend zu den Fig. 5, Fig. 6 und Fig. 7 mit unterschiedlichen Frequenzschemata näher dargestellt.

In dem AD-Wandlermodul 60 erfolgt zunächst die eigentliche Wandlung der analogen Eingangssignale durch ADC 61 (Analog-Digital-Converter), die mit einer zugeführten Taktfrequenz das Analogsignal abtasten und in eine digitale Form überführen.

Die Taktfrequenz kann über eine Signalleitung oder drahtlos von dem Magnetresonanztomographen 1 zugeführt werden, oder in der Lokalspule 50 lokal von einem zugeführten Signal durch einen lokalen Taktgenerator abgeleitet werden. Bei einer drahtlosen Lokalspule 50 ist es auch denkbar, dass der lokale Taktgenerator zumindest für eine vorbestimmte Zeit freilaufend arbeitet und nur in bestimmten Zeitabständen synchronisiert wird.

Als weitere Signalverarbeitung erfolgt beispielsweise in dem AD-Wandlermodul 60 das Erzeugen von sogenannten IQ-Signalen durch Mischen des gewandelten reellwertigen Magnetresonanzsignals mit zwei um 90 Grad gegeneinander phasenverschobenen digitalen Sinussignalen bzw. einem Sinus-Signal und einem Cosinus-Signal in den digitalen Mischern 62. Die Mischsignale werden durch einen digitalen IQ-Oszillator, den sogenannten Numerically Controlled Oszillator (NCO) 63 bereitgestellt. Auch hier erfolgt die Erzeugung vorzugsweise in Abhängigkeit von einem Referenztakt des Magnetresonanztomographen 1.

In dem dargestellten AD-Wandlermodul 60 erfolgt anschließend eine Datenratenreduktion durch einen Dezimationsfilter 64, bevor die Daten zur Übertragung an den Magnetresonanztomographen 1 in einem Serializer/Multiplexer 65 aufbereitet werden. Vorzugsweise erfolgt auch eine Hilbert-Transformation durch ein Hilbert-Filter, um ein reelles Signal zu erzeugen und auf diese Weise die Datenrate weiter zu reduzieren.

Fig. 5 zeigt ein beispielhaftes Spektrum eines Signals am Messpunkt A in Fig. 2 nach dem ADC 61. Das Magnetresonanzsignal taucht im Spektrum als reelles Signal symmetrisch zum Nullpunkt auf. Gemäß dem Nyquist-Theorem ist dabei das Signal unterhalb der halben Abtastfrequenz FS/2.

Das Signal des NCO 63 zum Heruntermischen des Zwischenfrequenzsignals ist physikalisch als digitales Schaltsignal auf dem ADC-DSP-Chip vorhanden. Die potenziell störenden Harmonischen dieses Rechteck-Signals erstrecken sich spektral bis weit über das MR-Empfangssignal hinaus. Als Problem bleibt daher zunächst bestehen, dass die NCO-Signal-Harmonischen höherer Ordnung in die Lokalspulen-Elemente oder in den ADC-Eingang einkoppeln können und durch die Abtastung potenziell in das Frequenzband des abgetasteten MR-Signals einfalten.

Die Datenrate des DDC-Ausgangssignals kann über den als Zweierpotenz wählbaren Dezimationsfaktor N reduziert werden. Hierbei ist zum einen die Nyquist-Bedingung einzuhalten. Zum anderen dürfen auch die Harmonischen des Daten-Taktsignals nicht in das Empfangsband oder Alias-Bänder der Abtastung fallen und so zu Bildartefakten führen. Im in Fig. 2 gezeigten Beispiel wurde N zu 16 gewählt, wodurch sich eine Ausgangsdatenrate von 2.5MS/s ergibt.

Die NCO-Frequenz wird derart gewählt, dass das resultierende Zwischenfrequenzsignal $ZF_{dig2}$ mittig in das 1. Nyquist-Band des DDC-Ausgangssignals fällt.

$$ZF_{dig2} = \frac{FS_{out}/2}{2} = \frac{2.5MHz/2}{2} = 0.625MHz$$

Hierdurch wird erreicht, dass

- symmetrisch um die Mittenfrequenz gleichviel Abstand zu 0Hz und FS/2 (1.25MHz) verbleibt, wodurch die Anforderungen an die Dezimations- und Hilbert-Filter möglichst gering gehalten werden
- das NCO-Signal spektral außerhalb des Frequenzbandes des digitalen MR-Signals zu liegen kommt

Die Frequenz des passenden NCO-Signals ergibt sich hiermit zu

$$F_{NCO\_initial} = 16.4MHz - 0.625MHz = 15.775MHz.$$

Die Auslegung des Frequenzplanes alleinig nach den oben angegebenen Kriterien führt jedoch dazu, dass zahlreiche Harmonische höherer Ordnung des NCO-Signals in das $ZF_{dig1}$-Signal Frequenzband (16.4MHz +-250kHz) gefaltet werden, so fällt z.B. die 34. Signal-Harmonische (536.35MHz) auf 16.350MHz.

Dieses Problem lässt sich umgehen, indem die NCO-Frequenz derart gewählt wird, dass sie durch Multiplikation der Nyquist-Frequenz (FS/2) mit einem aus ganzen Zahlen M und N gebildeten Quotienten M/N (also einer rationalen Zahl) dargestellt werden kann:

$$F_{NCO} = \frac{M}{N} * \frac{FS}{2}$$

Die Harmonischen dieses Signals fallen nach der Abtastung in ein fest vorgegebenes Frequenzraster von FS/(2*N). Der Rasterabstand muss eine Mindestgröße besitzen, damit sich das abgetastete MR-Signal spektral in das Raster einfügen kann, ohne eine der NCO-Harmonischen Einfaltungen einzuschließen:

$$F_{NCO} < ZF_{dig1} \; (Normallage): \quad \Delta F_{norm} > ZF_{dig1} + \frac{BW}{2} - F_{NCO}$$

$$F_{NCO} > ZF_{dig1} \; (Kehrlage): \quad \Delta F_{kehr} > F_{NCO} + \frac{BW}{2} - ZF_{dig1}$$

Hieraus lässt sich ein Maximalwert für die Wahl des Parameters N berechnen:

$$N_{max} = ABRUNDEN\left(\frac{FS/2}{\Delta F}\right)$$

Für größere N faltet sich entweder eine Harmonische in das $ZF_{dig1}$-Band, oder die Frequenzabweichung von der optimalen NCO-Frequenz wird zu groß.

Hiermit berechnet sich M zu:

$$M = RUNDEN\left(\frac{N * F_{NCO\_initial}}{FS/2}\right)$$

Durch versuchsweises Einsetzen von ganzen Zahlen in N, bis hin zu $N_{max}$, kann der Quotient M/N ermittelt werden, mit dem sich eine NCO-Frequenz mit geringstem Abstand zu $F_{NCO\_initial}$ ergibt. Im in Fig. 5 gezeigten Beispiel (Regellage) ergibt sich die optimale NCO-Frequenz mit N=19 gemäß:

$$F_{NCO\_opt} = \frac{15}{19} * \frac{40MHz}{2} = 15.78947 \ldots MHz$$

Die Abweichung zu $F_{NCO\_initial}$ beträgt 14.5kHz, bzw. ca. 0.09%, was mit Blick auf die spektrale Lage der resultierenden $ZF_{dig2}$ tolerierbar gering ist. Der Rasterabstand beträgt:

$$\Delta F = \frac{FS}{2 * N} = 1,0526 \ldots MHz$$

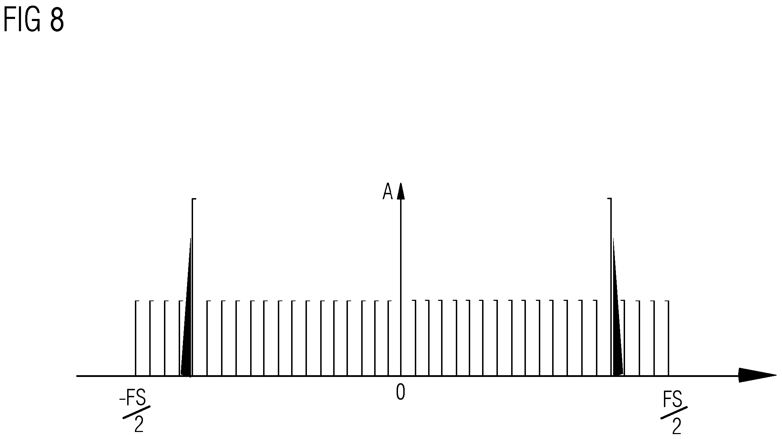

Fig. 8 zeigt für das vorliegende Beispiel die spektrale Lage des abgetasteten MR-Signals $ZF_{dig1}$ am Ausgang des ADCs sowie das durch eingefaltete NCO-Signal-Harmonische entstandene Frequenzraster. Das Spektrum des reellen $ZF_{dig1}$-Signals passt sich in das Raster ein, ohne eine der Spektrallinien einzuschließen.

Ein NCO-Signal mit der resultierenden Frequenz $F_{NCO\_opt}$ lässt sich mit einem NCO endlicher Auflösung nicht exakt erzeugen. Es verbleibt eine Frequenzabweichung aufgrund der erforderlichen Rundung des Frequenz-Abstimm-Wortes (FTW, Frequency Tuning Word):

$$FTW = RUNDEN\left(\frac{2^n * F_{NCO}}{FS}\right)$$

In dem gezeigten Beispiel entsteht bei Verwendung einer durch das AD-Wandlermodul 60 vorgegebenen NCO FTW Auflösung von 32bit und einer NCO-Taktfrequenz von 40MHz ein Frequenzfehler von ca. -3.4mHz. Hierdurch wird die spektrale Lage der eingefalteten NCO-Signal-Harmonischen mit zunehmender Harmonischen-Ordnung aufgefächert. Aufgrund der verschwindend geringen Größe des Frequenzfehlers sind jedoch trotzdem keine störenden Einfaltungen zu erwarten.

Nach der Datenreduktion durch den Dezimator 64 wird das resultierende $ZF_{dig2}$-Signal in einem Serializer 65 in einen seriellen Datenstrom gewandelt und über z.B. eine LVDS-Schnittstelle vom AD-Wandlermodul 60 an die nachfolgenden Funktionsblöcke übergeben. Hier kann sich ein in einem ASIC oder FPGA realisiertes Hilbert-Filter 72 anschließen, in dem durch frequenzunabhängige Relativ-Phasenschiebung der IQ-Signalkomponenten und anschließende vorzeichenrichtige Addition der beiden Komponenten des so entstandenen analytischen Signals das gewünschte Seitenband der Mischung selektiert (hier oberes Seitenband) und das Spiegel-Band unterdrückt wird. Am Ausgang des Summiergliedes 73 erscheint ein reellwertiges Signal mit $1 \times 2.5$MS/s, welches anschließend im Serialisierer 74 als serielles Datensignal über ein Kabel oder eine optische Faser übertragen werden kann. Insbesondere ist auch eine Drahtlose Übertragung des digitalen Signals durch einen Übertragungs-Sender 54 und einen Übertragungs-Empfänger 55 denkbar, der beispielsweise in einem GHz-ISM-Band arbeitet. Empfangsseitig in dem Magnetresonanztomographen 1 erfolgt die RX-Signalverarbeitung wie in einem bekannten IQ-Empfänger, bevor die Magnetresonanzsignale zur weiteren Verarbeitung, beispielsweise einer Bildrekonstruktion, bereitgestellt werden.

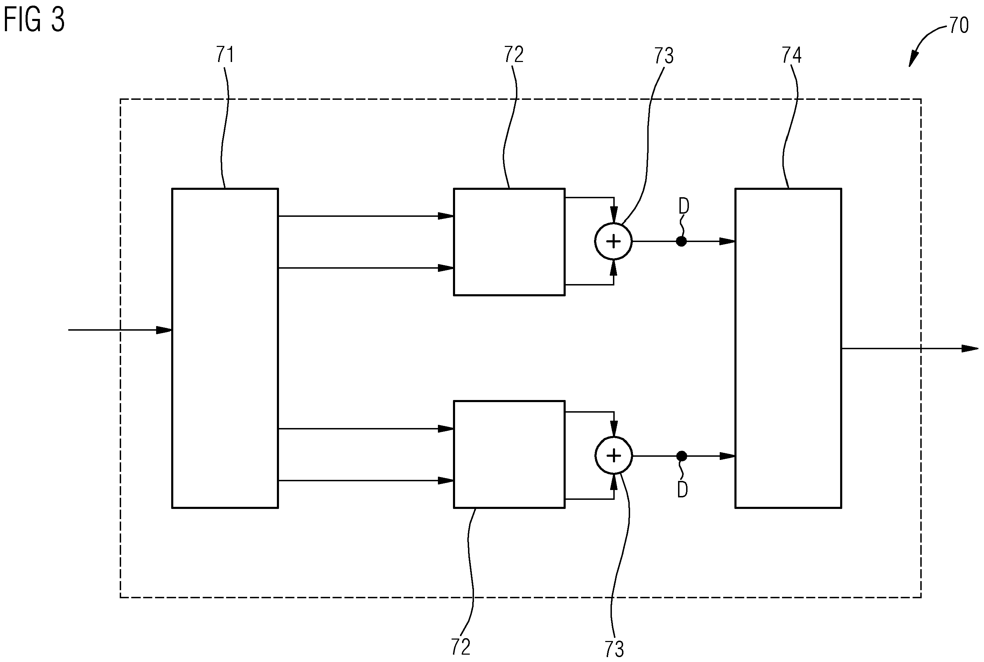

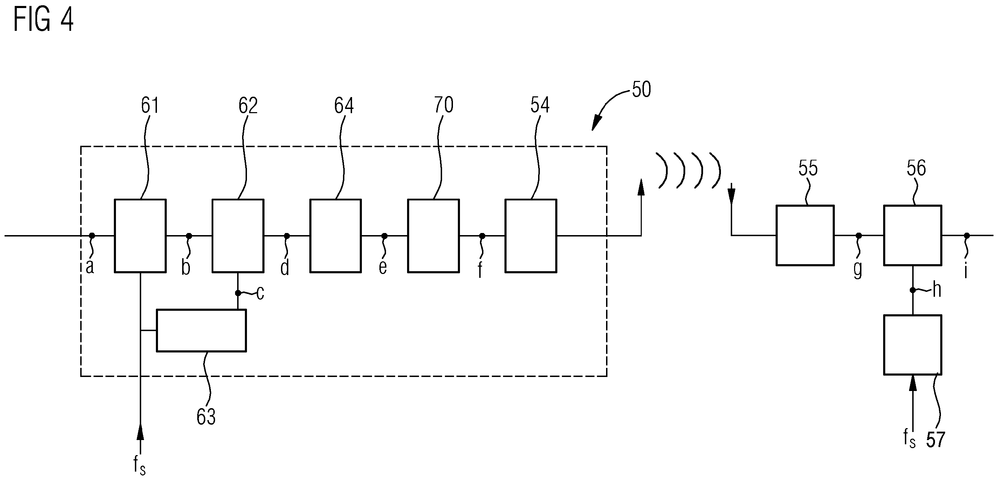

Fig. 4 zeigt eine bevorzugte Ausführungsform, in der das komplexe IQ-Signal vor der Übertragung an das MR-System in einem Seitenbandfilter 70 einer Hilbert-Transformation 72 unterzogen wird, siehe auf Fig. 3 mit den Details des Seitenbandfilters 70. Anschließend wird durch die Vorgabe der Vorzeichen für die folgende Addition 73 der Hilbert-Filter Ausgangssignale ausgewählt, ob Signale aus dem negativen, oder Signale aus dem positiven Frequenzbereich des komplexen Hilbert-Filter Eingangssignals weiterverwendet werden. Das reellwertige Ausgangssignal beansprucht im Vergleich zum komplexwertigen Eingangssignal lediglich die halbe Bandbreite. Entsprechend reduziert sich die Datenrate um den Faktor 0,5.

In Fig. 3 ist ein derartiges Seitenbandfilter 70 in einer Realisierung mit einem Hilbert-Filter beispielhaft dargestellt. Die Realisierung kann beispielsweise durch ein FPGA-Modul erfolgen. Zunächst werden die Datenströme der I- und Q-Signale mit einem Demultiplexer 71 wieder getrennt und anschließend den Hilbert-Transformatoren 72 zugeführt, die jeweils eine frequenzunabhängige Relativ-Phasenschiebung zwischen Imaginärteil und Realteil um 90° vornehmen. Anschließend werden die beiden Komponenten des Hilbert-Filter Ausgangssignals in einem Summierglied 73 addiert, sodass in Abhängigkeit von den gewählten Vorzeichen jeweils das Seitenband, das bei der Mischung entstanden ist und keine MR-Information enthält, eliminiert wird.

Jedoch ginge ohne Gegenmaßnahme aufgrund des vorliegenden Rundungsfehlers bei der Frequenzeinstellung des bei der Frequenzumsetzung beteiligten NCOs 63, und somit der geringen NCO-Frequenzabweichung von 3,4 mHz, die starre Phasenkopplung zwischen MRT Sende- und Empfangssystem verloren, da sich Sende- und Empfangssignale in der Praxis nicht mehr auf identische Zwischenfrequenzen mischen lassen.

In Fig. 4 ist eine beispielhafte Empfangskette eines erfindungsgemäßen Systems mit einer erfindungsgemäßen Lokalspule 50 dargestellt. Zur Übersicht sind nicht alle Einzelnen Elemente der vo9rhergehenden Figuren wiederholt. Das System sieht zum Erreichen einer starren Phasenkopplung eine Kompensationsvorrichtung vor, die einen Frequenzkonverter 56 und einen zweiten numerisch gesteuerten Oszillator NCO2 57 aufweist. Die Fig. 4 gibt hier auch noch einmal im Überblick die Signalverarbeitungsstufen der Fig. 2 wieder, um die Zusammenhänge der verwendeten Frequenzen zu veranschaulichen.

Hierbei werden zwei unterschiedliche beispielhafte Frequenzschemata betrachtet, für die die einzelnen Frequenzen an den einzelnen Referenzpunkten a bis i in Fig. 4 angegeben sind. Gemeinsam ist hier lediglich die Eingangsfrequenz des Magnetresonanzsignals, beispielhaft 63,600 MHz für einen Magnetresonanztomographen für 1.5 T.

Nach der AD-Wandlung im ADC 61 mit einer Abtastfrequenz fs ist das Magnetresonanzsignal am Punkt b in ein digitales reelles Magnetresonanzsignal umgesetzt. In Fig. 5 ist das Spektrum am Punkt b der Fig. 4 schematisch dargestellt. Dabei sind allerdings die Bandbreiten der einzelnen Signale nicht maßstabsgetreu wiedergegeben, sondern zur Verdeutlichung verbreitert. Das Signal bei +/- 16,4 MHz ist dabei das durch die Unterabtastung umgesetzte Magnetresonanzsignal, während der schraffierte Block den durch die Unterabtastung umgesetzten Rauschflur andeutet, der im Spiegelfrequenzband der nachfolgenden Mischung erscheint.

Der Mischer 62 mischt das Magnetresonanzsignal mit dem ersten Mischsignal des NCO 63 (Punkt c) mit einer Frequenz $F_{NCO1}$. Nach dem Mischer 62 und dem Dezimator 64 liegt am Punkt d das in der Frequenzlage umgesetzte Magnetresonanzsignal in Form eines komplexwertigen IQ-Zwischenfrequenzsignals vor.

Fig. 6 zeigt ein beispielhaftes Spektrum nach dem Mischen am Punkt d für die zu Fig. 5 angegebenen Frequenzen. Das Magnetresonanzsignal kommt dabei bei der positiven Frequenz 0,6105 MHz zu liegen, während das informationslose Rauschband im negativen Frequenzbereich zu liegen kommen. Angedeutet ist die Übertragungsfunktion des folgenden Dezimationsfilters. Das andere Produkt der Mischung faltet sich dabei in den Frequenzbereich um 7 MHz, also in den Sperrbereich des folgenden Dezimationsfilters. In Fig. 7 sind noch einmal die beiden Signale um den Frequenznullpunkt im Detail dargestellt, im negativen Bereich das rauschförmige Signal ohne MR-Information und um die positive Frequenz 610,5 kHz herum das Magnetresonanzsignal.

Nachfolgend wird das in Form eines IQ-Signals in Punkt d vorliegende MR-Signal mithilfe eines im Seitenbandfilter 70 integrierten Hilbert-Filters und Addierers in ein reellwertiges Signal am Punkt f überführt. Dabei wird, wie bereits zu Fig. 3 beschrieben, ein Seitenband unterdrückt bzw. ausgelöscht, hier das Seitenband im negativen Frequenzbereich mit rauschförmigem Signal ohne MR-Information.

Anschließend wird das reellwertige Signal von dem Sender 54 zu dem Empfänger 55 des Magnetresonanztomographen 1 übertragen welches dann auch am Punkt g vorliegt.

Hier erfolgt ein Mischen mit dem Frequenzkonverter 56 mit einem komplexwertigen Mischsignal des NCO2 57 (Punkt h), wodurch das Magnetresonanzsignal am Punkt i für eine weitere Verarbeitung bzw. Bildrekonstruktion vorliegt

Entspricht die Frequenz des NCO2-Signals exakt der Frequenz des NCO1-Signals, kann das $ZF_{dig2}$-Signal im Frequenzkonverter 56 wieder exakt auf die Frequenz $ZF_{dig1}$ zurück umgesetzt werden. Hierzu wird der NCO2 57 mit demselben FTW programmiert wie der NCO1 63 und mit derselben Taktfrequenz getaktet (40MHz). Über den Signalweg von Punkt b bis Punkt i gesehen bleiben die Manipulationen der spektralen Signallage daher transparent. Die NCO1 63 FTW Auflösung ist für den "off-the-shelf" AD-Wandlerbaustein 60 vorgegeben und kann dort nicht geändert werden. Auf Systemseite kann der NCO2 57 z.B. in einem FPGA realisiert werden, das eine FTW Auflösung von z.B. 64bit bietet. Hiermit kann ein 16.4000MHz NCO-Signal exakt erzeugt werden, mit dem das $ZF_{dig2}$-Signal dann in einem weiteren Frequenzumsetzer exakt symmetrisch um 0Hz in das komplexwertige Basisband umgesetzt wird. Alternativ kann die hohe Auflösung bereits im NCO2 57 dazu genutzt werden, das $ZF_{dig2}$-Signal unmittelbar im Frequenzumsetzer 56 in das komplexwertige Basisband umzusetzen.

In der nachfolgenden Tabelle werden die Signalfrequenzen an den Referenzpunkten für zwei unterschiedliche Szenarien aufgelistet:

| | Szenario 1 | Szenario 2 |
|---|---|---|
| a | 63,600 MHz | 63,600MHz |
| b | 16,400 MHz | 3,600 MHz |
| c | 1695381827 *fs / (2^32) | 920350135 *fs / (2^32) |
| d | | |
| e | ~ 610,526319 kHz @ 2,5 MS/s (complex) | ~ 685,714286 kHz @ 2,5 MS/s (complex) |
| f | ~ 610,526319 kHz @ 2,5 MS/s (real) | ~ 685,714286 kHz @ 2,5 MS/s (real) |
| g | ~ 610,526319 kHz @ 40 MS/s (real) | ~ 685,714286 kHz @ 20 MS/s (real) |

(fortgesetzt)

|  | Szenario 1 | Szenario 2 |
|---|---|---|
| h | 1695381827 *$f_s$ / (2^32) MHz | 920350135 *fs / (2^32) |
| i | 16,400 MHz @ 40 MS/s (real) | 3,600 MHz @ 10 MS/s (real) |
| fs | 40 MHz | 20 MHz |

Während das Szenario 1 den Frequenzen entspricht, die bereits in Verbindung mit der Fig. 5 diskutiert und berechnet wurde, entspricht das Szenario 2 den nachfolgenden Parametern:

$$FS = 20MS/s$$

$$N = 8 \quad (DDC\ Decimation\ Factor)$$

$$FS_{DDC} = \frac{FS}{N} = 2.5MHz \quad (DDC\ Output\ Sampling\ Frequency)$$

$$ZF_{dig1} = 3.600MHz$$

$$F_{NCO\_initial} = ZF_{dig1} + \frac{FS_{DDC}}{4} = 3.6MHz + \frac{2.5MHz}{4} = 4.225MHz \quad (Kehrlage)$$

$$F_{NCO} > ZF_{dig1}\ (Kehrlage):$$

$$\Delta F_{kehr} > F_{NCO} + \frac{BW}{2} - ZF_{dig1} = 4.225MHz + 0.35MHz - 3.6MHz = 0.975MHz$$

$$N_{max} = ABRUNDEN\left(\frac{FS/2}{\Delta F}\right) = ABRUNDEN\left(\frac{20MHz/2}{0.975MHz}\right) = 20$$

$$N_{opt} = 7 \quad (durch\ versuchsweises\ Einsetzen\ ermittelt)$$

$$M = RUNDEN\left(\frac{N_{opt} * F_{NCO\_initial}}{FS/2}\right) = RUNDEN\left(\frac{7 * 4.225MHz}{10MHz}\right) = 3$$

$$F_{NCO\_opt} = \frac{M}{N_{opt}} * \frac{FS}{2} = \frac{3}{7} * \frac{20MHz}{2} = 4,28571428571\ldots MHz$$

$$FTW = RUNDEN\left(\frac{2^{32} * 4,28571428571}{20}\right) = 920350135$$

**Patentansprüche**

1.   Lokalspule für einen Magnetresonanztomographen mit einem Analog-Digitalwandler, einem digitalen Mischer, einem Oszillator und einem Datenraten-Dezimator, wobei der Mischer und der Oszillator ausgebildet sind, ein digitalisiertes Magnetresonanzsignal derart in der Frequenzlage umzusetzen, dass das Magnetresonanzsignal spektral mittig in einen Frequenzbereich umgesetzt wird, der wahlweise dem positiven Frequenzteilbereich oder dem negativen Frequenzteilbereich des Basis-Bandes am Ausgang des folgenden Datenraten-Dezimators entspricht..

2. Lokalspule nach Anspruch 1, wobei der Mischer ein halb-komplexer Mischer ist.

3. Lokalspule nach einem der vorhergehenden Ansprüche, wobei der Oszillator ein IQnumerisch- gesteuerter Oszillator ist

4. Lokalspule nach einem der vorhergehenden Ansprüche, wobei der Oszillator ausgebildet ist, eine Frequenz des Oszillatorsignals außerhalb des Frequenzbereichs des abgetasteten MR-Signals zu erzeugen.

5. Lokalspule nach einem der vorhergehenden Ansprüche, wobei der Oszillator ausgebildet ist, ein Oszillatorsignal mit einer Frequenz zu erzeugen, dass ein Spektrum des abgetasteten MR-Signals zwischen zwei benachbarte Alias-Produkte des Oszillatorsignals fällt.

6. Lokalspule nach einem der vorhergehenden Ansprüche, wobei die Frequenz des Oszillatorsignals derart gewählt ist, dass sie durch Multiplikation der Nyquist-Frequenz mit einem Quotienten M/N dargestellt werden kann, wobei M und N ganzen Zahlen sind.

7. Lokalspule nach einem der vorhergehenden Ansprüche, wobei der digitale Mischer und der Analog-Digital-Wandler monolithisch ausgeführt sind.

8. Lokalspule nach einem der vorhergehenden Ansprüche, wobei die Lokalspule eine drahtlose Übertragungsvorrichtung aufweist und ausgebildet ist, das heruntergemischte digitale Magnetresonanzsignal drahtlos zu einem Magnetresonanztomographen zu übertragen.

9. System aus einem Magnetresonanzsystem und einer Lokalspule nach einem der Ansprüche 1 bis 8, wobei die Lokalspule ausgebildet ist, ein Referenzsignal von dem Magnetresonanztomographen über eine Signalverbindung zu erhalten und der Oszillator ausgebildet ist, eine Mischfrequenz für den Mischer in Abhängigkeit von einem Referenzsignal zu erzeugen.

10. System nach Anspruch 9, wobei eine Signalverarbeitungskette für Magnetresonanzsignale mindestens zwei Mischer und zwei numerisch gesteuerte Oszillatoren zum Erzeugen von Mischfrequenzen zur Frequenzumsetzung des Magnetresonanzsignals aufweist, wobei das System ausgebildet ist, eine Frequenzumsetzung des Magnetresonanzsignals in der Signalverarbeitungskette vorzunehmen, die einer Mischung des Magnetresonanzsignals mit einem virtuellen Mischsignal entspricht, wobei ein Quotient aus einer Frequenz des virtuellen Mischsignals und einer Frequenz des Referenzsignals eine rationale Zahl angibt.

11. System nach Anspruch 10, wobei ein Quotient aus einer Frequenz des virtuellen Mischsignals und einer Frequenz des Referenzsignals eine natürliche Zahl angibt.

12. System nach Anspruch 11, wobei die numerisch gesteuerten Oszillatoren derart eingestellt sind, dass in der Signalkette eine Frequenzumsetzung durch den ersten Mischer durch eine Frequenzumsetzung durch den zweiten Mischer kompensiert wird, sodass eine Frequenz eines Signals vor dem ersten Mischer gleich einer Frequenz eines Signals nach dem zweiten Mischer ist.

FIG 1

FIG 2

FIG 3

FIG 4

EP 4 760 325 A1

FIG 5

FIG 6

FIG 7

FIG 8

Europäisches
Patentamt

European
Patent Office

Office européen
des brevets

**EUROPÄISCHER RECHERCHENBERICHT**

Nummer der Anmeldung

EP 24 21 9415

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | GIOVANNETTI G ET AL: "Application of undersampling technique for the design of an NMR signals digital receiver", CONCEPTS IN MAGNETIC RESONANCE PART B: MAGNETIC RESONANCE ENGINEERING, WILEY, US, Bd. 29B, Nr. 3, 1. August 2006 (2006-08-01), Seiten 107-114, XP002750888, ISSN: 1552-5031, DOI: 10.1002/CMR.B.20065 [gefunden am 2006-07-14] * "Theory", "Materials and Methods" * * Abbildungen 3, 4 * ----- | 1-12 | INV. G01R33/36 |
| A | CN 1 588 110 A (UNIV EAST CHINA NORMAL [CN]) 2. März 2005 (2005-03-02) * Abbildungen 2, 3B * ----- | 1-12 | |
| A | SM VAROSI ET AL: "Multiplexing Applied to a Digital MR Receiver", INTERNATIONAL SOCIETY FOR MAGNETIC RESONANCE IN MEDICINE, ISMRM, 2030 ADDISON STREET, 7TH FLOOR, BERKELEY, CA 94704 USA, 19. August 1994 (1994-08-19), Seite 1009, XP040653662, * das ganze Dokument * ----- | 1-12 | **RECHERCHIERTE SACHGEBIETE (IPC)** G01R |
| A | US 5 594 341 A (MAJIDI-AHY REZA [US] ET AL) 14. Januar 1997 (1997-01-14) * das ganze Dokument * ----- | 1-12 | |

Der vorliegende Recherchenbericht wurde für alle Patentansprüche erstellt

| Recherchenort | Abschlußdatum der Recherche | Prüfer |
|---|---|---|
| München | 30. April 2025 | Streif, Jörg Ulrich |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

**EP 24 21 9415**

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

**30-04-2025**

| Im Recherchenbericht angeführtes Patentdokument | Datum der Veröffentlichung | Mitglied(er) der Patentfamilie | Datum der Veröffentlichung |
|---|---|---|---|
| CN 1588110 A | 02-03-2005 | KEINE | |
| US 5594341 A | 14-01-1997 | CA 2152705 A1 | 28-12-1995 |
| | | DE 19522571 A1 | 25-01-1996 |
| | | GB 2290875 A | 10-01-1996 |
| | | JP H08194043 A | 30-07-1996 |
| | | US 5594341 A | 14-01-1997 |

Für nähere Einzelheiten zu diesem Anhang : siehe Amtsblatt des Europäischen Patentamts, Nr.12/82